# EUROPEAN PATENT APPLICATION

(11) **EP 3 211 980 A1**
(43) Date of publication of application: **30.08.2017**
(21) Application number: 16156803.5
(22) Date of filing: 23.02.2016
(51) Int. Cl.: H05K 7/20

(54) **ARRANGEMENT FOR SUBSEA COOLING OF POWER ELECTRONIC CELLS**

(71) Applicant: ABB Schweiz AG, 5400 Baden (CH)
(72) Inventor: LANERYD, Tor, 745 93 Enköping (SE); LENDENMANN, Heinz, 722 18 Västerås (SE); CAGIENARD, Raphael, 5430 Wettingen (CH); WAGNER, Thomas, 5506 Mägenwil (CH); MISSING, Kim, 65100 Vaasa (FI); GRADINGER, Thomas, 5032 Aarau Rohr (CH)
(74) Representative: Savela, Reino Aleksi

(57) **Abstract**

There is presented an arrangement (15a) for subsea cooling of a power electronic cell (12). The arrangement comprises a tank (10). The tank (10) is filled with a dielectric fluid (11). The arrangement comprises at least one power electronic cell (12). The at least one power electronic cell (12) is placed in the tank (10). Each at least one power electronic cell (12) comprises semiconductor elements (1, 2) and capacitor elements (5). The at least one power electronic cell (12) is oriented such that, when the arrangement (15a) is installed, a majority of the semiconductor elements (1, 2) are positioned in an upper part of the tank (10) and a majority of the capacitor elements (5) are positioned in a lower part of the tank (10). There is also presented a method for providing such an arrangement.

## Description

### TECHNICAL FIELD

The invention relates to cooling arrangements, and particularly to arrangements for subsea cooling of power electronic cells.

### BACKGROUND

In general terms, electric subsea installations and devices usually demand high standards regarding durability, long-term functionality and independence during operation. Electric subsea installations that need to be cooled during operation, such as subsea converters, require an autonomous and durable cooling of its components. It is known to use a dielectric fluid (also known as liquid dielectric) such as a for example oil as a cooling fluid. In general, electric subsea installations need to be pressurized with the dielectric fluid, thus said fluid, which is preferably a liquid, should be, at least almost, incompressible. In general terms, the dielectric fluid thus is used to provide an incompressible medium and additionally as an electric insulation medium of components, such as power electronics building blocks (PEBBs), placed in the electric installation.

The oil may thus be used both for the cooling of the electric and electronic components of the subsea converter, and for the electric insulation. Because of the high reliability required, the subsea converter cooling system may be passive, i.e., without the need for a pump to achieve the cooling. The oil in the converter tank (and in any oil-to-sea-water heat exchanger) may thus be moved by natural convection only. Also the sea water cooling the oil-to-sea-water heat exchanger may be moved by natural convection only. Consequently, the cooling efficiency is limited, and the design of an economical cooling system may be challenging.

Hence there is still a need for improved mechanisms for subsea cooling of electronic components.

### SUMMARY

An object of embodiments herein is to provide efficient mechanisms for subsea cooling of electronic components.

According to a first aspect there is presented an arrangement for subsea cooling of a power electronic cell. The arrangement comprises a tank. The tank is filled with a dielectric fluid. The arrangement comprises at least one power electronic cell. The at least one power electronic cell is placed in the tank. Each at least one power electronic cell comprises semiconductor elements and capacitor elements. The at least one power electronic cell is oriented such that, when the arrangement is installed, a majority of the semiconductor elements are positioned in an upper part of the tank and a majority of the capacitor elements are positioned in a lower part of the tank.

Advantageously, this provides efficient subsea cooling of the power electronic cell.

According to a second aspect there is presented a method for providing an arrangement for subsea cooling of a power electronic cell. The arrangement is provided by providing a tank and filling the tank with a dielectric fluid; and placing at least one power electronic cell in the tank. Each at least one power electronic cell comprises semiconductor elements and capacitor elements. The at least one power electronic cell is placed such that, when the arrangement is installed, a majority of the semiconductor elements are positioned in an upper part of the tank and a majority of the capacitor elements are positioned in a lower part of the tank.

It is to be noted that any feature of the first and second aspects may be applied to any other aspect, wherever appropriate. Likewise, any advantage of the first aspect may equally apply to the second aspect, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Fig. 1 schematically illustrates an arrangement for subsea cooling of a power electronic cell according to state of the art;
Figs. 2-5 schematically illustrate arrangements for subsea cooling of a power electronic cell according to embodiments; and
Fig. 6 is a flow chart illustrating a method according to embodiments.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Power electronic equipment such as power converters, variable speed drives, or high voltage direct current (HVDC) valves can advantageously be submerged in a tank filled with a dielectric fluid (such as mineral oil, natural esters, etc.) which acts as electric insulation and cooling medium. The benefit is particularly large for power electronic equipment installed subsea, because the dielectric fluid can be used with a pressure compensation system to achieve an internal pressure close or equal to the external pressure.

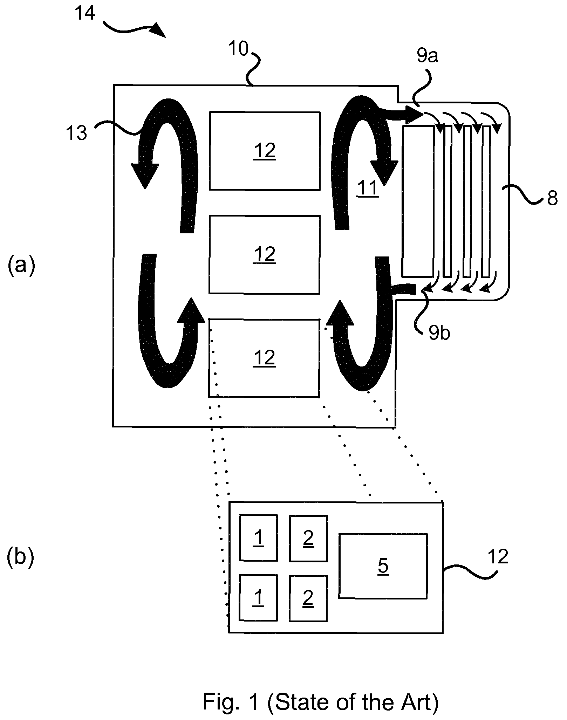

Fig. 1 at (a) schematically illustrates an arrangement 14 for subsea cooling of a power electronic cell 12 according to state of the art. The arrangement 14 comprises a tank 10. The tank 10 is filled with a dielectric fluid 11. The arrangement 14 further comprises power electronic cells 12. The power electronic cells 12 are placed in the tank 10. The power electronic cells 12 are thus submerged in the tank 10 filled with dielectric fluid 11. The power electronic cells 12 are arranged such that when the arrangement is in use, the power electronic cells 12 are vertically stacked. The arrangement 14 comprises a heat exchanger 8 attached to an outside of the tank 10. The heat exchanger 8 comprises an inlet 9a for receiving dielectric fluid 11 from the tank 10 and an outlet 9b for providing dielectric fluid 11 to the tank 10. Dielectric fluid 11 is thus received from the tank 10 at the inlet 9a, passed through the heat exchanger 8 and provided back to the tank 10 at the outlet 9b.

Cooling systems for electric equipment, such as arrangements for subsea cooling of power electronic cells provided in a tank, are thus used to cool down electric components, such as semiconductor elements, capacitor elements, transformers, power devices, etc. These components generate heat that needs to be dissipated by the cooling system. The cooling systems power electronic cells are usually designed in a simple manner avoiding any unnecessary parts and mechanisms. Generally it can be desirable to have passive cooling systems, thus cooling systems without any driven or powered parts, such as for example without pumps, to cool down the electric components. In some cases natural convection is used. Natural convection helps to avoid the use of a pump but it has a low efficiency. Cooling by natural convection uses the heat transfer from the cooling liquid to the surrounding sea water to generate circulation within the cooling system and thus within the electric installation and the tank. In some cases some kind of a heat exchanger is used to transfer heat from the cooling liquid to the sea water. In this respect the tank by itself acts as a heat exchanger and hence the heat exchanger can be denoted an external heat exchanger to make it clear that this heat exchanger is an heat exchanger in addition to the tank itself. For reliability, the cooling system of the arrangement 14 is passive and driven by natural convection as indicated by arrow 13. Hence, cooling of the power electronic cells 12 in the arrangement 14 is provided by natural convection.

The dielectric fluid will be heated up by power losses from the power electronic cells 12 and experience a buoyancy force upwards, while hot fluid in the vicinity of the tank walls will be cooled down and experience a buoyancy force downwards. This will create a circulating flow of dielectric fluid, according to arrow 13, in which heat is transferred to the external ambient environment. Due to the relatively low cooling performance of natural convection cooling, a large surface area of the tank 10 is required to keep a sufficiently low temperature for reliable long-term operation of the power electronic cells 12. However, for weight and volume considerations, the tank 10 should be kept as small as possible.

Power electronic devices typically have a topology which consists of a multitude of power electronic cells 12. Each power electronic cell 12 may comprise of a number of components which may include semiconductor elements and capacitors. Fig. 1 at (b) schematically illustrates one of the power electronic cells 12 of the arrangement 14. The power electronic cell 12 comprises semiconductor elements 1, 2 and capacitor elements 5. Hence, from the orientation of the power electronic cells 12 in the arrangement 14 and the orientation of the semiconductor elements 1, 2 and the capacitor elements 5 in each power electronic cell 12 follow that the power electronic cells 12 are vertically stacked and that separate streams of the dielectric fluid 11 will cool the semiconductor elements 1, 2 and the capacitor elements 5; in the example of Fig. 1, a left part of the dielectric fluid 11 will cool the semiconductor elements 1, 2 and a right part of the dielectric fluid 11 will cool the capacitor elements 5.

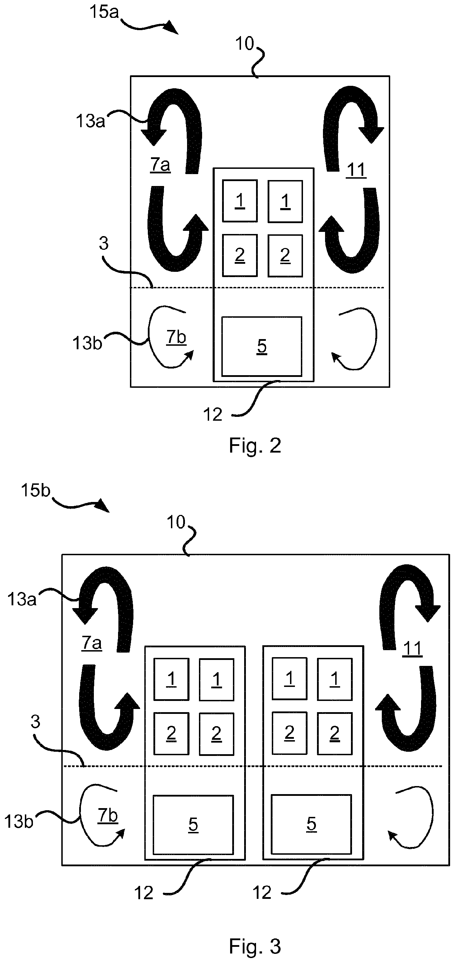

Reference is now made to Fig. 2 schematically illustrating an arrangement 15a for subsea cooling of a power electronic cell 12 according to an embodiment. The arrangement 15a comprises a tank 10. The tank 10 is filled with a dielectric fluid 11. The arrangement 15a further comprises a power electronic cell 12. The power electronic cell 12 is placed in the tank 10. The power electronic cell 12 is thus submerged in the tank 10 filled with dielectric fluid 11. In turn, the power electronic cell 12 comprises semiconductor elements 1, 2 and capacitor elements 5.

The power electronic cell 12 is constructed so that high loss, high temperature components (such as the semiconductor elements 1, 2) are placed on one side of the power electronic cell 12, and the low loss, low temperature components (such as the capacitors 5) are placed in the other side of the power electronic cell 12. The power electronic cell 12 is oriented in such a way that the high loss components are vertically above and the low loss components are below an imagined horizontal plane 3. The power electronic cell 12 is thus oriented such that, when the arrangement 15a is installed (for example at a seabed), a majority of the semiconductor elements 1, 2 are positioned in an upper part 7a of the tank 10 and a majority of the capacitor elements 5 are positioned in a lower part 7b of the tank 10. The upper part 7a and the lower part 7b are divided from each other by the imagined horizontal plane 3.

In this respect there can be different ways to define what is meant by a majority of the semiconductor elements 1, 2 are and a majority of the capacitor elements 5. According to an embodiment the term majority means that at least 70 %, 80 %, 90 % or 95 % of the semiconductor elements 1, 2 are positioned in the upper part 7a of the tank 10 and at least 70 %, 80 %, 90 % or 95 % of the capacitor elements 5 are positioned in the lower part 7b of the tank 10.

The semiconductor elements 1, 2 are characterized in that they generate the majority of losses and that they are relatively insensitive to high temperatures. The capacitors 5 are characterized in that they generate a minor amount of losses, and that they are relatively sensitive to high temperatures. The power electronic cell 12 is therefore designed in such a way that all constitutive components are in an environment with a temperature that is lower than the limit for reliable long-term operation. Furthermore, the constitutive components are arranged close together to ensure a good performance. In general terms, in use, the upper part 7a of the tank 10 contains hot fluid with large flow circulation 13a, whereas the lower part 7b of the tank 10 is cold with less circulation 13b or nearly stagnant fluid. For this reason the temperature sensitive components (i.e., the capacitor elements 5) experience a cold environment and the less sensitive components (i.e., the semiconductor elements 1, 2) experience a hot environment. Consequently the external cooling surface of the tank 10 can be kept small whilst ensuring a suitable environment temperature for reliable long term operation of all constitutive components of the power electronic cell 12.

Examples of semiconductor elements are diodes 1 and insulated-gate bipolar transistors (IGBTs) 2. According to an embodiment the semiconductor elements 1, 2 are arranged, when the arrangement 15a is installed, such that the diodes 1 are positioned vertically higher than the IGBTs 2.

In general terms, diodes 1 and IGBTs 2 are high loss components and thus placed in the upper part 7a of the tank 10 whereas the low loss capacitor elements 5 are placed in the lower part 7b of the tank 10. Advantageously the diodes 1 are designed to have lower losses than the IGBTs 2, so that the temperature rise over local fluid temperature is lower. Since the dielectric fluid 11 is heating up while moving upwards, the diodes 1 and IGBTs 2 will thereby have a more evenly distributed temperature.

Cooling of the power electronic cell 12 in the arrangement 15a is provided by natural convection, as indicated by arrows 13a, 13b. Hence, when the power electronic cell 12 is in use, the dielectric fluid 11 circulates by natural convection as indicated by arrows 13a, 13b. In more detail, during operation of the power electronic cell 12, a natural convection flow of the dielectric fluid 11 will be generated by the buoyancy force caused by the temperature increase due to heat losses. For the high loss components, this will generate both a relatively large temperature increase and a relatively large mass flow of dielectric fluid 11. The resulting natural convection cooling loop may only encompass the upper part 7a of the tank 10 (above the imagined horizontal plane 3) as defined by arrow 13a.

Reference is now made to Fig. 3 schematically illustrating an arrangement 15b for subsea cooling of a power electronic cell 12 according to an embodiment. The arrangement 15b comprises all features of the arrangement 15a and for brevity the description of those features is omitted. In addition thereto, the arrangement 15b comprises two power electronic cells 12, each comprising semiconductor elements 1, 2 and capacitor elements 5. The arrangement 15b thereby symbolizes an arrangement 15b comprising a plurality of power electronic cells 12. A multitude of power electronic cells 12 could compose a power electronic device and be arranged so that the imagined horizontal plane 3 coincides for all power electronic cells 12. Hence, according to the embodiment of Fig. 3, the plurality of power electronic cells 12 are positioned, when the arrangement 15b is installed, side by side at same vertical height in the arrangement 15b.

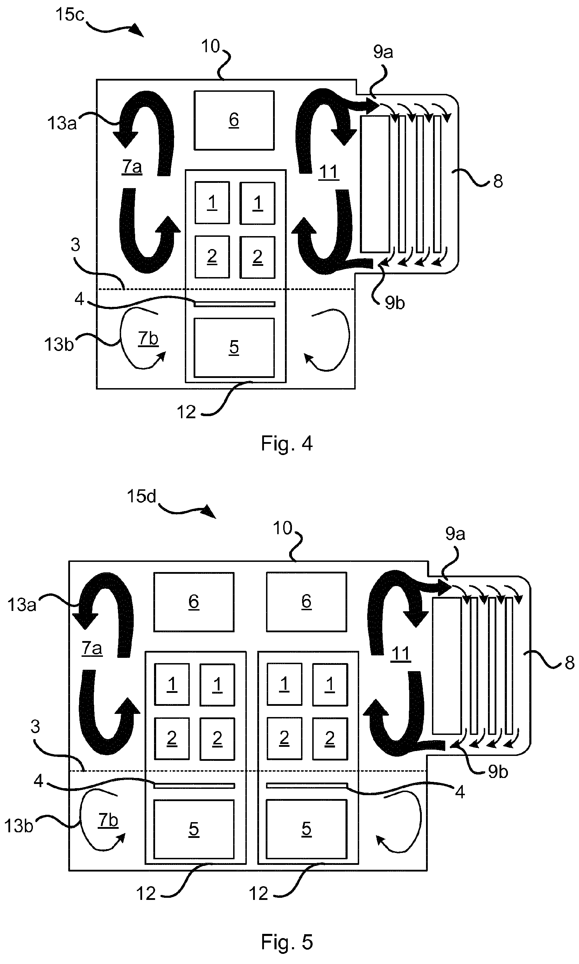

Reference is now made to Fig. 4 schematically illustrating an arrangement 15c for subsea cooling of a power electronic cell 12 according to an embodiment. The arrangement 15c comprises all features of the arrangement 15a and for brevity the description of those features is omitted.

In addition to the arrangement 15a, the arrangement 15c further comprises a control board 4. Advantageously the control board 4 can be mounted in the space between IGBTs 2 and capacitors 5. This provides a fast connection between the IGBT 2 and the gate driver, as well as keeping the control board 4 in the cold fluid in the lower part 7b of the tank 10. The control board 4 is hence positioned between the semiconductor elements 1, 2 and the capacitor elements 5 in the power electronic cell 12.

Advantageously a power device 6 can be placed in the tank 10. In addition to the arrangement 15a, the arrangement 15c thus further comprises at least one power device 6. The at least one power device 6 is placed in the tank 10. Further, the at least one power device 6 is positioned such that, when the arrangement 15c is installed, the at least one power device 6 is located in the upper part 7a of the tank 10. In the illustrative example of Fig. 4 the at least one power device 6 is positioned vertically higher than the power electronic cell 12. There could be different examples of power devices 6. For example, each at least one power device 6 could be a transformer.

Advantageously the arrangement 15c comprises a heat exchanger 8. In addition to the arrangement 15a, the arrangement 15c thus further comprises a heat exchanger 8. The heat exchanger 8 is attached to an outside of the tank 10. The heat exchanger 8 is oriented such that, when the arrangement 15c is installed, the heat exchanger 8 is positioned outside the upper part 7a of the tank 10. The heat exchanger 8 is in fluid communications with the interior of the tank 10. In more detail, the heat exchanger 8 of Fig. 4 comprises an inlet 9a for receiving dielectric fluid 11 from the tank 10 and an outlet 9b for providing dielectric fluid 11 to the tank 10. Dielectric fluid 11 is thus received from the tank 10 at the inlet 9a, passed through the heat exchanger 8 and provided back to the tank 10 at the outlet 9b. Advantageously the outlet 9b of the heat exchanger 8 is be placed vertically above the imagined horizontal plane 3 dividing the tank 10. The heat exchanger 8 is thus arranged such that, when the arrangement 15c is installed, the outlet 9b is placed vertically higher than the capacitor elements 5. Further, in the illustrative example of Fig. 4 the inlet 9a is placed vertically higher than the outlet 9b. Additionally, according to one embodiment the heat exchanger 8 is oriented such that, when the arrangement 15c is installed, the heat exchanger 8 is positioned above the upper part 7a of the tank 10.

Reference is now made to Fig. 5 schematically illustrating an arrangement 15d for subsea cooling of a power electronic cell 12 according to an embodiment. The arrangement 15d comprises all features of the arrangement 15c and for brevity the description of those features is omitted. In addition thereto, the arrangement 15d comprises two power electronic cells 12, each comprising semiconductor elements 1, 2 and capacitor elements 5. The arrangement 15d thereby symbolizes an arrangement comprising a plurality of power electronic cells 12. Hence, the arrangement 15d is a combination of the arrangement 15b of Fig. 3 and the arrangement 15c of Fig. 4.

The tank wall surface can be extended through corrugations or cooling fins or cooling pins. Advantageously only the surface of the upper part 7a (including the roof part) of the tank 10 is used for such surface extension. Hence, according to an embodiment the tank 10 comprises a vertical part and a horizontal part, and the vertical part and/or the horizontal part has a surface extension extending length of the vertical part and/or the horizontal part. The horizontal part is preferably defined by the roof of the tank 10. The vertical part preferably corresponds to the tank wall at the upper part 7a of the tank 10.

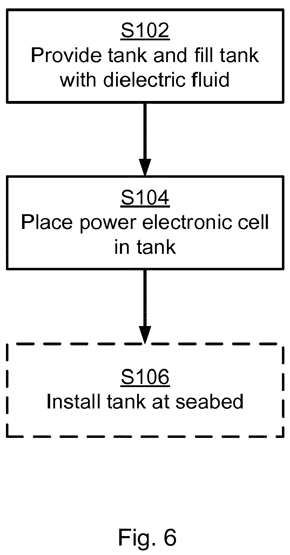

Reference is now made to Fig. 6 illustrating methods for providing an arrangement 15a, 15b, 15c, 15d for subsea cooling of a power electronic cell 12. The arrangement 15a, 15b, 15c, 15d is provided by steps S102 and S104 being performed:
S102: A tank 10 is provided and filled with a dielectric fluid 11.
S104: At least one power electronic cell 12 is placed in the tank 10. As disclosed above, each at least one power electronic cell 12 comprises semiconductor elements 1, 2 and capacitor elements 5.

The arrangement 15a, 15b, 15c, 15d is provided in steps S102 and S104 such that the at least one power electronic cell 12 is placed such that, when the arrangement 15a, 15b, 15c, 15d is installed, the semiconductor elements 1, 2 are positioned in an upper part 7a of the tank 10 and the capacitor elements 5 are positioned in a lower part 7b of the tank 10.

According to an optional step S106, the tank 10 of the arrangement 15a, 15b, 15c, 15d is installed on a seabed. Preferably, steps S102 and S104 are performed prior to step S106.

The invention has mainly been described above with reference to a few embodiments. However, as is readily appreciated by a person skilled in the art, other embodiments than the ones disclosed above are equally possible within the scope of the invention, as defined by the appended patent claims. Further, as the skilled person understands, any feature associated with the herein disclosed arrangements 15a, 15b, 15c, 15d for subsea cooling of a power electronic cell 12 may also be associated with the herein disclosed method for providing an arrangement 15a, 15b, 15c, 15d for subsea cooling of a power electronic cell 12. For example, the herein disclosed arrangements 15a, 15b, 15c, 15d are advantageously used for medium voltage drives with a cascade H-bridge (CHB) medium voltage drive topology but are not considered limited to this topology or this application.

## Claims

1. An arrangement (15a, 15b, 15c, 15d) for subsea cooling of a power electronic cell (12), the arrangement (15a, 15b, 15c, 15d) comprising:
a tank (10), the tank (10) being filled with a dielectric fluid (11); and
at least one power electronic cell (12) placed in the tank (10), each at least one power electronic cell (12) comprising semiconductor elements (1, 2) and capacitor elements (5),
wherein the at least one power electronic cell (12) is oriented such that, when the arrangement (15a, 15b, 15c, 15d) is installed, a majority of the semiconductor elements (1, 2) are positioned in an upper part (7a) of the tank (10) and a majority of the capacitor elements (5) are positioned in a lower part (7b) of the tank (10).

2. The arrangement (15a, 15b, 15c, 15d) according to claim 1, wherein, when the at least one power electronic cell (12) is in use, the dielectric fluid (11) circulates by natural convection (13a, 13b).

3. The arrangement (15a, 15b, 15c, 15d) according to any of the preceding claims, wherein the semiconductor elements (1, 2) comprise diodes (1) and insulated-gate bipolar transistors, IGBTs (2).

4. The arrangement (15a, 15b, 15c, 15d) according to claim 3, wherein the semiconductor elements (1, 2) are arranged, when the arrangement (15a, 15b, 15c, 15d) is installed, such that the diodes (1) are positioned vertically higher than the IGBTs (2).

5. The arrangement (15a, 15b, 15c, 15d) according to any of the preceding claims, wherein the at least one power electronic cell (12) further comprises:
a control board (4), the control board (4) being positioned between the semiconductor elements (1, 2) and the capacitor elements (5) in the at least one power electronic cell (12).

6. The arrangement (15a, 15b, 15c, 15d) according to any of the preceding claims, wherein the arrangement (15a, 15b, 15c, 15d) comprises a plurality of the at least one power electronic cell (12), and wherein the plurality of power electronic cells (12) are positioned, when the arrangement (15a, 15b, 15c, 15d) is installed, side by side at same vertical height in the arrangement (15a, 15b, 15c, 15d).

7. The arrangement (15a, 15b, 15c, 15d) according to any of the preceding claims, further comprising:
at least one power device (6) placed in the tank (10),
wherein the at least one power device (6) is oriented such that, when the arrangement (15a, 15b, 15c, 15d) is installed, the at least one power device (6) is positioned in said upper part (7a) of the tank (10).

8. The arrangement (15a, 15b, 15c, 15d) according to claim 7, wherein the at least one power device (6) is a transformer.

9. The arrangement (15a, 15b, 15c, 15d) according to any of the preceding claims, wherein the tank (10) comprises a vertical part and a horizontal part, and wherein the vertical part and/or the horizontal part has a surface extension extending length of the vertical part and/or the horizontal part.

10. The arrangement (15a, 15b, 15c, 15d) according to any of the preceding claims, further comprising:
a heat exchanger (8) attached to an outside of the tank (10),
wherein the heat exchanger (8) is oriented such that, when the arrangement (15a, 15b, 15c, 15d) is installed, the heat exchanger (8) is positioned outside the upper part (7a) of the tank (10).

11. The arrangement (15a, 15b, 15c, 15d) according to claim 10, wherein the heat exchanger (8) is oriented such that, when the arrangement (15a, 15b, 15c, 15d) is installed, the heat exchanger (8) is positioned above the upper part (7a) of the tank (10).

12. The arrangement (15a, 15b, 15c, 15d) according to claim 10 or 11, wherein the heat exchanger (8) comprises:
an inlet (9a) for receiving dielectric fluid (11) from the tank (10); and
an outlet (9b) for providing dielectric fluid (11) to the tank (10),
wherein the outlet (9b) is placed, when the arrangement (15a, 15b, 15c, 15d) is installed, vertically higher than the capacitor elements (5).

13. The arrangement (15a, 15b, 15c, 15d) according to any of the preceding claims, wherein the at least one power electronic cell (12) is oriented such that, when the arrangement (15a, 15b, 15c, 15d) is installed, 70 %, 80 %, 90 % or 95 % of the semiconductor elements (1, 2) are positioned in the upper part (7a) of the tank (10) and 70 %, 80 %, 90 % or 95 % of the capacitor elements (5) are positioned in the lower part (7b) of the tank (10).

14. A method for providing an arrangement (15a, 15b, 15c, 15d) for subsea cooling of a power electronic cell (12), wherein the arrangement (15a, 15b, 15c, 15d) is provided by:
providing (S102) a tank (10) and filling the tank (10) with a dielectric fluid (11); and
placing (S104) at least one power electronic cell (12) in the tank (10), each at least one power electronic cell (12) comprising semiconductor elements (1, 2) and capacitor elements (5);
wherein the at least one power electronic cell (12) is placed such that, when the arrangement (15a, 15b, 15c, 15d) is installed, a majority of the semiconductor elements (1, 2) are positioned in an upper part (7a) of the tank (10) and a majority of the capacitor elements (5) are positioned in a lower part (7b) of the tank (10).

15. The method according to claim 13, further comprising:
installing (S106) the tank (10) of the arrangement (15a, 15b, 15c, 15d) at a seabed.
